# EUROPEAN PATENT APPLICATION

(11) **EP 4 387 132 A1**
(43) Date of publication of application: **19.06.2024**
(21) Application number: 22854886.3
(22) Date of filing: 14.03.2022
(51) Int. Cl.: H04L 1/00

(54) **PATTERN INFORMATION ACQUISITION METHOD AND APPARATUS, ELECTRONIC DEVICE, AND READABLE STORAGE MEDIUM**

(30) Priority: 09.08.2021 CN 202110908574
(71) Applicant: Sanechips Technology Co., Ltd., Shenzhen, Guangdong 518055 (CN)
(72) Inventor: DING, Jialong, Shenzhen, Guangdong 518057 (CN)
(74) Representative: Ipsilon
(86) International application number: PCT/CN2022/080657
(87) International publication number: WO 2023/015881

(57) **Abstract**

The present application provides a pattern information acquisition method and apparatus, an electronic device, and a readable storage medium. The method includes: sorting, according to reliability weight information of polar codes, a sequence to be processed to obtain a weight-based sequence; performing sequence search on the weight-based sequence to obtain a search result sequence, where the sequence search is used for acquiring a sequence corresponding to data having a reliability weight within a preset reliability threshold range; and mapping the search result sequence to the sequence to be processed to obtain pattern information that indicates position information of data of the search result sequence in the sequence to be processed.

## Description

### TECHNICAL FIELD

The present application relates to the technical field of communications, and in particular relates to a pattern information acquisition method and apparatus, an electronic device, and a readable storage medium.

### BACKGROUND

The data transmission rate in the 5^{th} generation mobile communication technology (5G) is significantly increased compared to that in the 4^{th} generation mobile communication technology (4G). In order to obtain a higher data transmission rate to meet the user requirement of low-latency communication, polar codes may be adopted in 5G for coding and decoding of the communication data. The polar code is a coding scheme of high reliability.

Pattern information is desired in coding and decoding of the communication data with polar codes. However, a calculation process of pattern information is a process of repeated iteration and weight sorting on the data, leading to a very slow coding and decoding speed and making it impossible to obtain a higher data transmission rate.

### SUMMARY

The present application provides a pattern information acquisition method and apparatus, an electronic device, and a readable storage medium.

An embodiment of the present application provides a pattern information acquisition method, including: sorting, according to reliability weight information of polar codes, a sequence to be processed to obtain a weight-based sequence; performing sequence search on the weight-based sequence to obtain a search result sequence, wherein the sequence search is used for acquiring a sequence corresponding to data having a reliability weight within a preset reliability threshold range; and mapping the search result sequence to the sequence to be processed to obtain pattern information that indicates position information of data of the search result sequence in the sequence to be processed.

An embodiment of the present application further provides a pattern information acquisition apparatus, including: an acquisition module configured to sort, according to reliability weight information of polar codes, a sequence to be processed to obtain a weight-based sequence; a search module configured to perform sequence search on the weight-based sequence to obtain a search result sequence, wherein the sequence search is used for acquiring a sequence corresponding to data having a reliability weight within a preset reliability threshold range; and a mapping module configured to map the search result sequence to the sequence to be processed to obtain pattern information that indicates position information of data of the search result sequence in the sequence to be processed.

An embodiment of the present application provides a decoder, including the pattern information acquisition apparatus according to the present application.

An embodiment of the present application provides an electronic device, including: one or more processors; and a memory having one or more programs stored thereon which, when executed by the one or more processors, cause the one or more processors to implement the pattern information acquisition method according to the present application.

An embodiment of the present application provides a readable storage medium having a computer program stored thereon which, when executed by a processor, causes the pattern information acquisition method according to the present application to be implemented.

With respect to the above embodiments and other aspects of the present application and implementations thereof, further description is provided in the brief description of drawings, the detailed description of embodiments, and the claims.

### BRIEF DESCRIPTION OF DRAWINGS

FIG. 1 is a schematic flowchart of a pattern information acquisition method according to the present application;
FIG. 2 is another schematic flowchart of a pattern information acquisition method according to the present application;
FIG. 3 is a block diagram of a pattern information acquisition apparatus according to the present application;
FIG. 4 is a block diagram of a decoder according to the present application;
FIG. 5 is a further block diagram of a decoder according to the present application;
FIG. 6 is a schematic flowchart of an operating method of a decoder according to the present application; and
FIG. 7 is a block diagram showing an exemplary hardware architecture of a computing device capable of implementing the pattern information acquisition method and apparatus according to the present application.

### DETAIL DESCRIPTION OF EMBODIMENTS

For clarity and better understanding of the objects, technical solution and advantages of the application, embodiments of the present application will now be described in detail in conjunction with the accompanying drawings. It should be noted that the embodiments of the present application and features therein may be combined with each other in any manner as long as they are not contradictory.

The polar code is a coding scheme of high reliability which selects a code with higher reliability through a processing mode of channel polarization. Data to be transmitted are coded or decoded with polar codes, and then transmitted over different channels. At present, the polar code is the only coding scheme that is strictly proved to reach the Shannon limit.

Pattern information is desired in coding and decoding of the communication data with polar codes. Calculation for obtaining the pattern information may be implemented as follows.

Firstly, according to parameters such as a data length of an input sequence, a data length of communication information and the like, a frozen bit position for a first round is found based on an interleaving rule of polar codes; and an information bit position for the first round is back-marked based on the frozen bit position for the first round.

Then, based on the information bit position for the first round and the reliability weight information of the polar codes, a position with the highest reliability weight is selected from the information bit position for the first round as the information bit position for a second round. The number of selected bits is a sum data length of a communication information sequence, a cyclic redundancy check sequence, and a modulo five check sequence.

The remaining positions are marked as frozen bit positions for the second round. Then, under a condition that a modulo five check sequence is determined in the information bit position for the second round, the modulo five check sequence may be composed of a first check sequence (e.g., a normal pc (npc) sequence) and a second check sequence (e.g., a minimum row weight pc (wmpc) sequence), or may be composed entirely of the first check sequence. When the modulo five check sequence includes the second check sequence, position information of the second check sequence in the modulo five check sequence, and position information corresponding to the final communication information sequence, are desired to be found out based on a Kronecker matrix and reliability weight information. The Kronecker matrix is an n × n matrix, through which a row weight-based sequence with a length n is obtained. A position with a higher weight is selected as the second check sequence of the modulo five check sequence. Under the condition of same weights, a position with higher reliability according to the reliability weight information of the polar codes is selected, where n is an integer greater than or equal to 1.

In the above processing method, in order to improve the decoding performance, a frozen check bit has to be added; and a position of higher reliability is desired to be selected from the frozen bit positions for the second round as the frozen check bit, while the rest positions serve as final frozen bits. In this processing method, repeated iteration and weight sorting are performed to sequentially find out pattern information of each piece of decoded data, which is likely to lead to a very slow coding and decoding speed and make it impossible to obtain a higher data transmission rate.

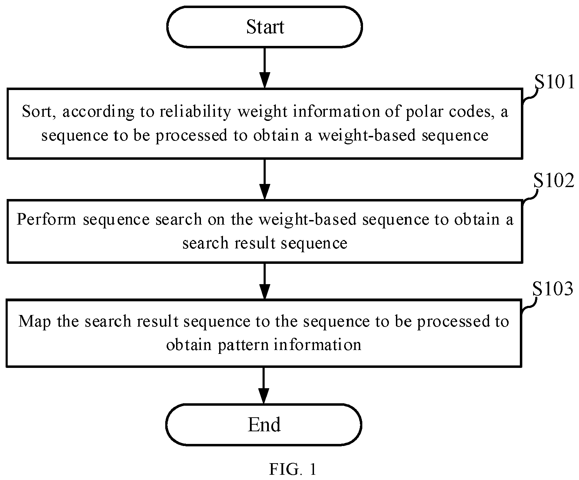

FIG. 1 is a schematic flowchart of a pattern information acquisition method according to the present application. This pattern information acquisition method may be applied to a pattern information acquisition apparatus that may be arranged in a decoder. As shown in FIG. 1, the pattern information acquisition method of the present application may include the following operations S101 to S103.

At operation S101, sort, according to reliability weight information of polar codes, a sequence to be processed to obtain a weight-based sequence.

The polar code selects a code with higher reliability through a processing mode of channel polarization. During processing of the polar code, pre-configured reliability weight information is desired, which may represent reliability weights of data at different coding positions.

However, the reliability weights of various pieces of data in the sequence to be processed are not arranged in order, and a weight-based sequence is obtained by sorting the sequence to be processed according to the reliability weight information of the polar codes, so as to ensure that the pieces of data in the weight-based sequence are arranged in order, to facilitate subsequent processing and improve the processing efficiency of the sequence.

At operation S102, perform sequence search on the weight-based sequence to obtain a search result sequence.

The sequence search is used for acquiring a sequence corresponding to data having a reliability weight within a preset reliability threshold range. For example, the preset reliability threshold range may be an integer or the like. The above preset reliability threshold range is merely illustrated by way of example, and other unexplained reliability threshold ranges are also within the protection range of the present application, and may be specifically set according to specific situations, which are not described in detail here.

After the processing in operation S101, the weight-based sequence is arranged in order, and all the reliability weights of the data in the search result sequence are data within the preset reliability threshold range, which not only reduces the range of the sequence to be processed, but also ensures accuracy of the obtained search result sequence.

At operation S103, map the search result sequence to the sequence to be processed to obtain pattern information.

The pattern information may indicate position information of data of the search result sequence in the sequence to be processed.

The search result sequence may include a plurality of different types of sequences, and position information corresponding to the respective types of sequences. By mapping the search result sequence to the sequence to be processed, position information, i.e., pattern information, of each type of sequence in the search result sequence in the sequence to be processed can be obtained. With such pattern information, position information of different types of sequences in the sequence to be processed can be defined, thereby accelerating decoding of the sequence to be processed, and increasing the decoding efficiency.

By sorting, according to reliability weight information of polar codes, the sequence to be processed to obtain the weight-based sequence, the reliability weight corresponding to each piece of data in the sequence to be processed is clearer, thereby shortening the processing time and facilitating subsequent processing. By performing sequence search on the weight-based sequence to obtain the search result sequence, the search result sequence can be obtained without repeated iteration, thereby improving the screening speed of data with a reliability weight meeting the preset reliability threshold. By mapping the search result sequence to the sequence to be processed to obtain pattern information that indicates position information of data of the search result sequence in the sequence to be processed, decoding of the sequence to be processed is facilitated, and the decoding speed is increased.

In some specific implementations, before the operation S101 of sorting, according to reliability weight information of polar codes, the sequence to be processed to obtain the weight-based sequence, the method may further include: acquiring a data length of the communication information sequence, a data length of an input sequence, and a matched data length; determining position information of an initial frozen bit according to the data length of the communication information sequence, the data length of the input sequence, the matched data length, and an interleaving rule of the polar codes; and determining the sequence to be processed according to the position information of the initial frozen bit and the input sequence.

The matched data length is a data length of a sequence obtained after the input sequence is subjected to rate matching. The rate matching means matching the coded sequence with a transmission resource of an antenna, so as to obtain the matched data length and facilitate the decoder to perform data transmission of the decoded data.

The block interleaving rule of the polar codes means scrambling the decoded data in units of blocks to improve the decoding efficiency. According to the interleaving rule of the polar codes, and in combination with the data length of the communication information sequence, the data length of the input sequence and the matched data length, the initial frozen bit is parsed from the input sequence, position information of the initial frozen bit is determined, and thus preliminary bit positioning information is obtained. Then, based on the position information of the initial frozen bit, an initial communication information sequence may be back-marked in the input sequence to obtain the sequence to be processed, so as to eliminate useless sequences, reduce the sequence range to be decoded, and improve the processing efficiency of the input sequence.

In some specific implementations, the operation S102 of performing sequence search on the weight-based sequence to obtain the search result sequence may be implemented by: screening the weight-based sequence according to a preset search threshold to obtain the search result sequence, where data of the search result sequence has a reliability weight within the preset reliability threshold range; and marking position information corresponding to a target code in the search result sequence.

The preset search threshold may be an integer of 10, 20, or the like, and by screening the weight-based sequence to obtain data having a reliability weight within the preset reliability threshold range, and obtaining the search result sequence according to the preset search threshold, the number of data pieces in the search result sequence may be equal to the preset search threshold, so as to reduce the processing range of the sequence.

For example, if the weight-based sequence is 512-bit binary data, and the preset search threshold may be set to 16 bits, then 16 bits of "1" may be truncated from a start bit position of the weight-based sequence to obtain the search result sequence. Since the reliability weights of the data in the weight-based sequence are arranged in order (for example, in a descending order), the data in the obtained search result sequence has a reliability weight of 16 bits, which is the highest in the weight-based sequence. Then, position information corresponding to a target code in the search result sequence is marked. For example, a position corresponding to "1" in the 16-bit search result sequence is marked, so that the data included in the search result sequence, as well as position information corresponding to the data, can be specifically determined. A sequence with the highest reliability weight can be obtained without repeated iteration and sequence sorting, thereby increasing the sequence search speed.

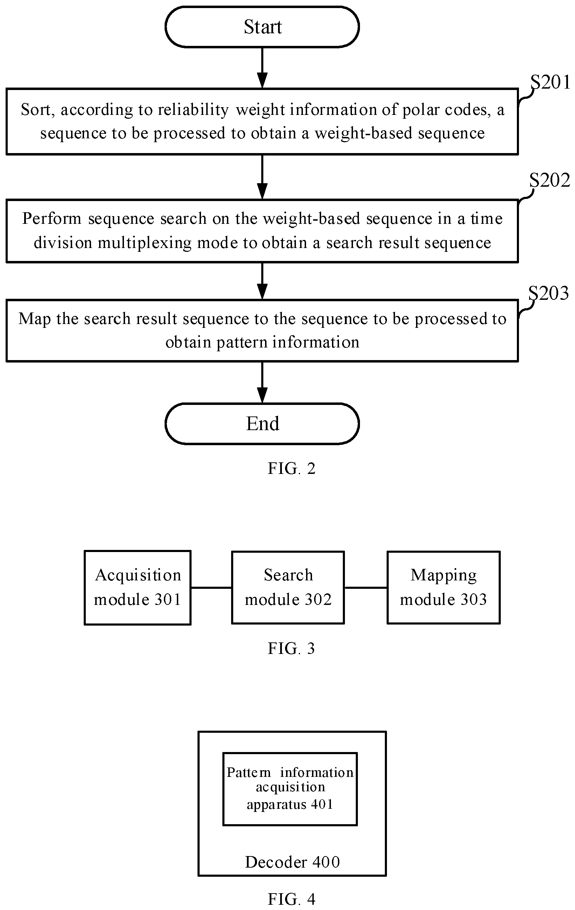

FIG. 2 is another schematic flowchart of a pattern information acquisition method according to the present application. This pattern information acquisition method may be applied to a pattern information acquisition apparatus that may be arranged in a decoder. This method differs from the method shown in FIG. 1 in that sequence search on the weight-based sequence is performed in a time division multiplexing mode to obtain the search result sequence, so that the search speed of the weight-based sequence can be accelerated, and different types of sequences can be obtained without repeated iteration.

As shown in FIG. 2, the pattern information acquisition method of the present application may include the following operations S201 to S203.

At operation S201, sort, according to reliability weight information of polar codes, a sequence to be processed to obtain a weight-based sequence.

The reliability weight information of the polar codes may include: preset data position information, and a reliability weight corresponding to the preset data position information.

For example, operation S201 may be implemented by: searching the reliability weight information of the polar codes according to the position information of the data in the sequence to be processed, to obtain a reliability weight corresponding to the data in the sequence to be processed; and sorting, according to the reliability weight corresponding to the data in the sequence to be processed, the data in the sequence to be processed in a descending order to obtain the weight-based sequence.

The preset data position information in the reliability weight information of the polar codes may include: position information of data in the sequence to be processed. For example, if the position information of the data in the sequence to be processed is data of a 4^{th} bit, data of a 4^{th} bit in the reliability weight information of the polar codes is found out to obtain a reliability weight corresponding to the data of the 4^{th} bit.

By sorting, according to the reliability weight corresponding to the data in the sequence to be processed, the data in the sequence to be processed in a descending order to obtain the weight-based sequence, the data in the weight-based sequence can have certain regularity. For example, data with a higher reliability weight is arranged at a front position in the weight-based sequence, while data with a lower reliability weight is arranged at a rear position in the weight-based sequence, so as to facilitate subsequent further processing on the weight-based sequence, and accelerate the processing speed of the sequence.

At operation S202, perform sequence search on the weight-based sequence in a time division multiplexing mode to obtain a search result sequence.

The weight-based sequence may include a plurality of different types of sequences. For example, the weight-based sequence is a sequence in which different types of sequences are interleaved with each other.

The time division multiplexing mode refers that by means of a same sequence search and resource storage on different types of sequences in the weight-based sequence, extraction is performed at different time points of the streamlined processing according to a correlation of the search sequence, and each different type of sequence is restored and finally the weight-based sequence is updated to a result of different types of sequences, so that the processing resources are greatly saved while basically not influencing the processing speed.

In some specific implementations, the operation S202 of performing sequence search on the weight-based sequence in a time division multiplexing mode to obtain the search result sequence, may include: performing sequence search on the weight-based sequence in a time division multiplexing mode to obtain a frozen check sequence, a modulo five check sequence, and a first search sequence.

The modulo five check sequence is used for marking a position of a modulo five check bit in the decoding result, the frozen check sequence is used for marking a position of a frozen check bit in the decoding result, and both can be used for checking correctness of the decoding result and ensuring the accuracy of decoding.

In some specific implementations, performing sequence search on the weight-based sequence in a time division multiplexing mode to obtain the frozen check sequence, the modulo five check sequence, and the first search sequence may include: acquiring a priority of the modulo five check sequence, a priority of the frozen check sequence, and a priority of the first search sequence; performing sequence search on the weight-based sequence in a time division multiplexing mode according to the priorities, to obtain first check data in the frozen check sequence and the modulo five check sequence; and performing sequence search on the weight-based sequence according to the priorities, to obtain the first search sequence.

The priority of each type of sequence is proportional to the reliability weight thereof. Therefore, data with a higher reliability weight can be processed first. In particular, wmpc check data requires selecting position information according to a row weight of a Kronecker matrix. If a plurality of selected positions have the same column weight, the plurality of positions may be screened again according to the reliability weights, and a position with a higher weight is selected as the position information corresponding to the wmpc check data.

For example, the greater the reliability weight of a sequence, the higher the priority of the sequence. A sequence with a higher priority level will be processed first, so to ensure that important data is identified as soon as possible and ensure the accuracy of decoding.

By searching the reliability weight information of the polar codes, it shows that the modulo five check sequence has a higher reliability weight than the frozen check sequence, and thus, the modulo five check sequence is determined to have a higher priority than the frozen check sequence.

In a time division multiplexing mode, the first search sequence is firstly found in the weight-based sequence, and then based on the position information corresponding to the first search sequence and in a sequence search mode, a mixed sequence of the first search sequence and the modulo five check sequence is obtained. By comparing the mixed sequence with the first search sequence, first check data of the modulo five check sequence can be obtained. By analogy, the frozen check sequence can be obtained correspondingly. As a result, different types of check sequences can be screened out, omission of a check sequence is avoided, and accuracy of the obtained pattern information is guaranteed.

At operation S203, map the search result sequence to the sequence to be processed to obtain pattern information.

It should be noted that operation S203 is the same as operation S103 shown in FIG. 1, and thus is not repeated here.

By sorting, according to the reliability weight corresponding to the data in the sequence to be processed, the data in the sequence to be processed in a descending order to obtain the weight-based sequence, the data in the weight-based sequence can have certain regularity, so as to facilitate subsequent further processing on the weight-based sequence, and accelerate the processing speed of the sequence. By performing sequence search on the weight-based sequence in a time division multiplexing mode, a search result sequence formed by combining a plurality of types of result sequences is obtained, so that the processing time of layered iteration is shortened and the processing efficiency is improved, and by further mapping the search result sequence to the sequence to be processed to obtain the pattern information, the efficiency of obtaining the pattern information can be improved while the accuracy of the pattern information is guaranteed.

In some specific implementations, after performing sequence search on the weight-based sequence according to the priorities to obtain the first search sequence, the method may further include: determining, according to a data length of the first search sequence and a preset length threshold, position information corresponding to a second check data.

The modulo five check sequence may include: the second check data including wmpc check data.

A data length of the first search sequence is judged by means of the preset length threshold, and under the condition that the data length of the first search sequence meets the requirement of the preset length threshold, various kinds of alternative position information can be obtained. Then, position information corresponding to the wmpc check data is obtained by screening from the various kinds of alternative position information according to an actual situation, thereby increasing the processing efficiency of the wmpc check data, without processing of a complex matrix, and notably increasing the screening speed of the wmpc check data.

In some specific implementations, determining, according to the data length of the first search sequence and the preset length threshold, the position information corresponding to the second check data may include: under a condition that the data length of the first search sequence is determined to be within a range of the preset length threshold, determining a position type set corresponding to the second check data, where the position type set corresponding to the second check data includes a number of position types and a position type corresponding to the second check data, and the number of position types corresponds to the preset length threshold; selecting the position type corresponding to the second check data from the position type set corresponding to the second check data; and determining, according to the position type corresponding to the second check data, position information corresponding to the second check data.

For example, under a condition that the data length of the first search sequence is determined to be within a range of the preset length threshold (e.g., 18, 19, or the like), the position type corresponding to the second check data can be obtained for the data length of the first search sequence, thereby increasing the screening speed of the second check data as well as the decoding speed.

In some specific implementations, the operation S203 of mapping the search result sequence to the sequence to be processed to obtain the pattern information may include: mapping the communication information sequence, the cyclic redundancy check sequence, the modulo five check sequence, and the frozen check sequence to the sequence to be processed, to obtain the pattern information.

The search result sequence may include a plurality of types of sequences, such as a communication information sequence, a cyclic redundancy check sequence, a modulo five check sequence, a frozen check sequence, and the like.

In some specific implementations, after performing sequence search on the weight-based sequence according to the priorities to obtain the first search sequence, the method may further include: performing sequence search on the first search sequence according to the priorities, to obtain a communication information sequence and a cyclic redundancy check sequence.

Since the communication information sequence has a higher priority than the cyclic redundancy check sequence, the communication information sequence can be searched from the first search sequence first, and then the cyclic redundancy check sequence is obtained. Therefore, the position information corresponding to the communication information sequence, and the position information corresponding to the cyclic redundancy check sequence, are accurately obtained.

Furthermore, by mapping the communication information sequence, the cyclic redundancy check sequence, the modulo five check sequence, and the frozen check sequence to the sequence to be processed, the corresponding position information of different types of sequences in the sequence to be processed can be obtained, so that accurate pattern information is obtained, and the accuracy of subsequent decoding is ensured.

In some specific implementations, after the operation S203 of mapping the search result sequence to the sequence to be processed to obtain the pattern information, the method may further include: determining, according to the pattern information, decoding start position information in the sequence to be processed.

The pattern information indicates position information of data of each of the different types of sequences in the input sequence. For example, the pattern information may include position information of the communication information sequence in the input sequence, position information of the cyclic redundancy check sequence in the input sequence, position information of a npc sequence in the modulo five check sequence in the input sequence, position information of the frozen check sequence in the input sequence, and position information of wmpc check data in the modulo five check sequence in the input sequence.

Since the sequence to be processed contains some useless sequences, by referring to various pieces of position information in the pattern information, the decoding start position information in the sequence to be processed can be quickly located, and the initial useless sequences can be skipped, thereby accelerating the decoding speed and increasing the decoding efficiency.

A pattern information acquisition apparatus according to an embodiment of the present application will be described in detail below with reference to the accompanying drawings. FIG. 3 is a block diagram of a pattern information acquisition apparatus according to the present application. As shown in FIG. 3, the pattern information acquisition apparatus may include: an acquisition module 301, a search module 302, and a mapping module 303.

The acquisition module 301 is configured to sort, according to reliability weight information of polar codes, a sequence to be processed to obtain a weight-based sequence.

The search module 302 is configured to perform sequence search on the weight-based sequence to obtain a search result sequence, where the sequence search is used for acquiring a sequence corresponding to data having a reliability weight within a preset reliability threshold range.

The mapping module 303 is configured to map the search result sequence to the sequence to be processed to obtain pattern information that indicates position information of data of the search result sequence in the sequence to be processed.

In the pattern information acquisition apparatus according to the present application, the acquisition module sorts, according to reliability weight information of polar codes, a sequence to be processed to obtain the weight-based sequence, so that the reliability weight corresponding to each piece of data in the sequence to be processed is clearer, thereby shortening the processing time and facilitating subsequent processing. The search module performs sequence search on the weight-based sequence to obtain the search result sequence, so that the search result sequence can be obtained without repeated iteration, thereby improving the screening speed of data with a reliability weight meeting the preset reliability threshold. The mapping module maps the search result sequence to the sequence to be processed to obtain pattern information that indicates position information of data of the search result sequence in the sequence to be processed, so that decoding of the sequence to be processed is facilitated, and the decoding speed is increased.

FIG. 4 is a block diagram of a decoder according to the present application. As shown in FIG. 4, the decoder 400 may include a pattern information acquisition apparatus 401 configured to implement any of the above pattern information acquisition methods according to the present application.

In some specific implementations, the pattern information acquisition apparatus 401 may include: an acquisition module configured to sort, according to reliability weight information of polar codes, a sequence to be processed to obtain a weight-based sequence; a search module configured to perform sequence search on the weight-based sequence to obtain a search result sequence, where the sequence search is used for acquiring a sequence corresponding to data having a reliability weight within a preset reliability threshold range; and a mapping module configured to map the search result sequence to the sequence to be processed to obtain pattern information that indicates position information of data of the search result sequence in the sequence to be processed.

In the decoder according to the embodiments of the present application, the acquisition module in the pattern information acquisition apparatus sorts, according to reliability weight information of polar codes, a sequence to be processed to obtain the weight-based sequence, so that the reliability weight corresponding to each piece of data in the sequence to be processed is clearer, thereby shortening the processing time and facilitating subsequent processing. The search module in the pattern information acquisition apparatus performs sequence search on the weight-based sequence to obtain the search result sequence, so that the search result sequence can be obtained without repeated iteration, thereby improving the screening speed of data with a reliability weight meeting the preset reliability threshold. The mapping module in the pattern information acquisition apparatus maps the search result sequence to the sequence to be processed to obtain pattern information that indicates position information of data of the search result sequence in the sequence to be processed, so that decoding of the sequence to be processed is facilitated, and the decoding speed is increased.

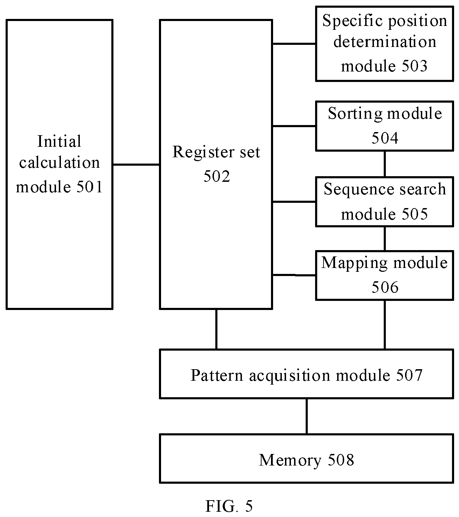

FIG. 5 is a further block diagram of a decoder according to the present application. As shown in FIG. 5, the decoder may include: an initial calculation module 501, a register set 502, a specific position determination module 503, a sorting module 504, a sequence search module 505, a mapping module 506, a pattern acquisition module 507, and a memory 508.

The initial calculation module 501 is configured to: acquire a data length of a communication information sequence, a data length of an input sequence, and a matched data length; calculate, according to the data length of the communication information sequence, the data length of the input sequence and the matched data length, a communication information bit position for a first round of an input sequence to obtain a sequence to be processed; and output the sequence to be processed to the register set 502, so that the register set 502 stores the sequence to be processed and the communication information bit position for the first round.

The specific position determination module 503 is configured to determine, according to the data length of the first search sequence and the matched data length, position information corresponding to a second check data in a modulo five check sequence. The matched data length may be a length threshold (e.g., 18 or the like) determined in advance, i.e., a preset length threshold, and the first search sequence is a mixed sequence of the communication information sequence and a cyclic redundancy check sequence.

The sorting module 504 is configured to sort, according to reliability weight information of polar codes, a sequence to be processed to obtain a weight-based sequence.

The sequence search module 505 is configured to perform sequence search on the weight-based sequence input from the sorting module 504 to obtain a search result sequence. The sequence search may be performed multiple times to search for position information of data in different sequences, so as to acquire a sequence corresponding to data having a reliability weight within a preset reliability threshold range.

The mapping module 506 is configured to map the search result sequence to the sequence to be processed to obtain position information of data of the search result sequence in the sequence to be processed.

The pattern acquisition module 507 is configured to aggregate the position information output from the mapping module 506 and the register set 502 into pattern information, and output the pattern information to the memory 508.

The memory 508 is configured to store the pattern information output from the pattern acquisition module 507 to facilitate the subsequent coding and decoding.

The memory 508 may be a random access memory (RAM) which, in an operating state, allows information to be written into or read from any designated address at any time. The RAM may be used for temporary storage of data.

In some specific implementations, the register set 502 may be implemented by four sets of 1024-bit sequence storage space, where the four sets of 1024-bit sequence storage space may respectively record: th communication information sequence, the cyclic redundancy check sequence, the modulo five check sequence, and a frozen check sequence. In addition, the four sets of 1024-bit sequence storage space may repeatedly store intermediate result data during the sequence search, so as to increase the sequence search speed.

In some specific implementations, the sequence search module 505 may process the input weight-based sequence as follows. For example, the weight-based sequence is a set of 1024-bit binary data, and the sequence search module 505 may, according to a preset reliability threshold (for example, input value sel_n, sel_n may be an integer greater than or equal to 1 and less than or equal to 1024), keep the 1024-bit weight-based sequence unchanged from the 0^{th} bit to the (sel_n-1)^{th} bit and set the (sel_n)^{th} bit to the 1023^{th} bit to 0, so as to screen out the search result sequence which is binary data including sel_n bits. In addition, the mapping module 506 marks a position of "1" in the binary data of sel_n bits of the search result sequence in the sequence to be processed.

In this embodiment, the sorting module 504 sorts, according to reliability weight information of polar codes, a sequence to be processed to obtain the weight-based sequence, so that the reliability weight corresponding to each piece of data in the sequence to be processed is clearer, thereby shortening the processing time and facilitating subsequent processing. The sequence search module 505 performs sequence search on the weight-based sequence to obtain the search result sequence, so that the search result sequence can be obtained without repeated iteration, thereby improving the screening speed of data with a reliability weight meeting the preset reliability threshold. The mapping module 506 maps the search result sequence to the sequence to be processed to obtain position information of data of the search result sequence in the sequence to be processed; and, in combination with the wmpc check data obtained by the specific position determination module 503, aggregates the position information output from the mapping module 506 and the register set 502 into pattern information through the pattern acquisition module 507, so that decoding of the sequence to be processed is facilitated, and the decoding speed is increased.

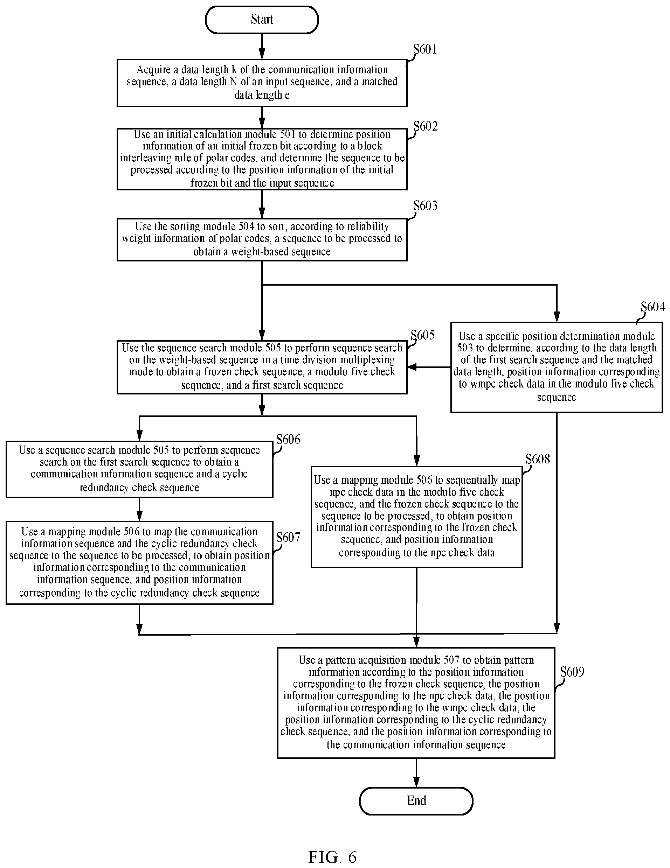

FIG. 6 is a schematic flowchart of an operating method of a decoder according to the present application. As shown in FIG. 6, the operating method of the decoder may include the following operations S601 to S609.

At operation S601, acquire a data length k of a communication information sequence, a data length N of an input sequence, and a matched data length e.

The matched data length is a data length of a sequence obtained after the input sequence is subjected to rate matching.

It should be noted that the rate matching refers to matching an input sequence with a transmission rate supportable by an antenna resource, so as to obtain the matched data length and facilitate the decoder to perform data transmission of the decoded data.

At operation S602, use the initial calculation module 501 to determine position information of an initial frozen bit according to a block interleaving rule of polar codes, and determine the sequence to be processed according to the position information of the initial frozen bit and the input sequence.

Based on the position information of the initial frozen bit, an information bit position for a first round can be back-marked, and thus, the sequence to be processed can be determined according to the information bit position for the first round.

At operation S603, use the sorting module 504 to sort, according to reliability weight information of polar codes, the sequence to be processed to obtain a weight-based sequence.

The reliability weight information of the polar codes may include: preset data position information, and a reliability weight corresponding to the preset data position information. The sequence to be processed may include a plurality of different types of sequences, and the position information corresponding to each of the different types of sequences is uncertain. By sorting, according to reliability weight information of polar codes, a sequence to be processed with the sorting module 504, data in the sequence to be processed can be arranged based on the reliability weights, so that the obtained weight-based sequence has certain regularity, which is convenient for subsequent processing.

For example, if the sequence to be processed is sorted in a descending order, the 0^{th} bit data of the obtained weight-based sequence has the highest reliability weight, then the 1^{st} bit data, ..., and the last bit data of the obtained weight-based sequence has the lowest reliability weight.

At operation S604, use the specific position determination module 503 to determine, according to the data length of a first search sequence and the matched data length, position information corresponding to wmpc check data in a modulo five check sequence.

Under a condition that the data length of the first search sequence is determined to be within a range of the preset length threshold (e.g., 18, 19, 25 or the like), a position type set corresponding to the wmpc check data is determined, which includes: a number of position types and a position type corresponding to the wmpc check data, and the number of position types corresponds to the preset length threshold; the position type corresponding to the wmpc check data is selected from the position type set corresponding to the wmpc check data; and according to the position type corresponding to the wmpc check data, the position information corresponding to the wmpc check data is determined.

For example, under a condition that the data length of a k_r_tmp sequence is determined to be within a range of the preset length threshold, a plurality of position types corresponding to the wmpc check data may be obtained according to a data length of the k_r_tmp sequence, and then one of the position types is selected as the position information corresponding to the wmpc check data, thereby increasing the screening speed of the wmpc check data, as well as the acquisition speed of the pattern information.

It should be noted that operation S604 may be executed after operation S601, after operation S602, or after operation S603, as long as operation S604 is finished before operation S605.

At operation S605, use the sequence search module 505 to perform sequence search on the weight-based sequence in a time division multiplexing mode to obtain a frozen check sequence, the modulo five check sequence, and the first search sequence.

For example, the weight-based sequence is represented by an i_tmp_forward sequence, which is subjected to sequence search by the sequence search module 505 to obtain the frozen check sequence first. Then, the modulo five check sequence is determined from position information of the frozen check sequence, and finally, the first search sequence is determined from position information of the modulo five check sequence (for example, represented by a k_r_tmp sequence).

The first search sequence, i.e., the k_r_tmp sequence, is a sequence in which the communication information sequence is mixed with a cyclic redundancy check (CRC) sequence. The modulo five check sequence may include first check data, or first check data and second check data.

It should be noted that, under a condition that the modulo five check sequence is determined to include the first check data and the second check data (for example, the second check data may include wmpc check data), the result of operation S604 (i.e., the position information corresponding to the wmpc check data in the modulo five check sequence) is used to clarify the position information corresponding to the modulo five check sequence in operation S605. By matching the obtained position information corresponding to the wmpc check data with the position information corresponding to the modulo five check sequence in operation S605, the specific position information corresponding to the modulo five check sequence is further defined, and the accuracy of the position information corresponding to the modulo five check sequence is guaranteed.

The sequence search module 505 performs sequence search on the weight-based sequence in a time division multiplexing mode to obtain the frozen check sequence, the modulo five check sequence, and the first search sequence, so that the processing speed of the sequence to be processed is accelerated.

At operation S606, use the sequence search module 505 to perform sequence search on the first search sequence to obtain the communication information sequence and the cyclic redundancy check sequence.

It should be noted that the sequence search module 505 may be repeatedly used to process different types of sequences, so as to clarify the position information corresponding to the data in each different sequence. Operation S608 may be performed simultaneously with operation S606.

At operation S607, use the mapping module 506 to map the communication information sequence and the cyclic redundancy check sequence to the sequence to be processed, to obtain position information corresponding to the communication information sequence, and position information corresponding to the cyclic redundancy check sequence.

Since the communication information sequence (for example, represented by a k_tmp sequence) has a higher priority than the cyclic redundancy check sequence (for example, represented by an r_tmp sequence), the k_tmp sequence may be mapped to the sequence to be processed first to obtain position information of the k_tmp sequence in the sequence to be processed (for example, represented by a k sequence), and then the r_tmp sequence is mapped to the sequence to be processed to obtain position information of the r_tmp sequence in the sequence to be processed (for example, represented by an r sequence).

At operation S608, use the mapping module 506 to sequentially map npc check data in the modulo five check sequence, and the frozen check sequence to the sequence to be processed, to obtain position information corresponding to the frozen check sequence, and position information corresponding to the npc check data.

The modulo five check sequence (for example, represented by an npc_tmp sequence) has a higher priority than the frozen check sequence (for example, represented by a far_tmp sequence). Since the npc_tmp sequence has a higher reliability weight than the far_tmp sequence, the npc_tmp sequence has a higher priority than the far_tmp sequence.

The npc check data in the modulo five check sequence is mapped to the sequence to be processed first, to obtain position information of the npc check data in the sequence to be processed (for example, represented by an npc sequence); and then, the frozen check sequence is mapped to the sequence to be processed, to obtain position information of the frozen check sequence in the sequence to be processed (for example, represented by a far sequence).

At operation S609, use the pattern acquisition module 507 to obtain pattern information according to the position information corresponding to the frozen check sequence, the position information corresponding to the npc check data, the position information corresponding to the wmpc check data, the position information corresponding to the cyclic redundancy check sequence, and the position information corresponding to the communication information sequence.

The pattern information indicating position information corresponding to data in each of the different types of sequences may be obtained from the position information corresponding to the k sequence and the position information corresponding to the r sequence obtained in operation S607, the position information corresponding to the npc sequence and the position information corresponding to the far sequence obtained in operation S608, and the position information corresponding to the wmpc check data obtained in operation S604.

Furthermore, a decoding start position can be quickly located according to the pattern information, thereby accelerating the decoding speed.

In this embodiment, the sequence search module 505 performs sequence search on the different input sequence types in a time division multiplexing mode, thereby saving resources; and the mapping module 506 maps the sequence output from the sequence search module 505 to the sequence to be processed, to obtain the position information of different sequences in the sequence to be processed, and then the pattern information is obtained through the pattern acquisition module 507, and used for quick location of the decoding start position, so that decoding of the input sequence is facilitated, and the decoding speed is increased.

It should be noted that the present application is not limited to the specific configurations and processing described in the above embodiments and shown in the figures. For convenience and simplicity of description, detailed description of a known method is omitted here, and for the specific working processes of the system, the modules and the units described above, reference may be made to corresponding processes in the foregoing method embodiments, which are not repeated here.

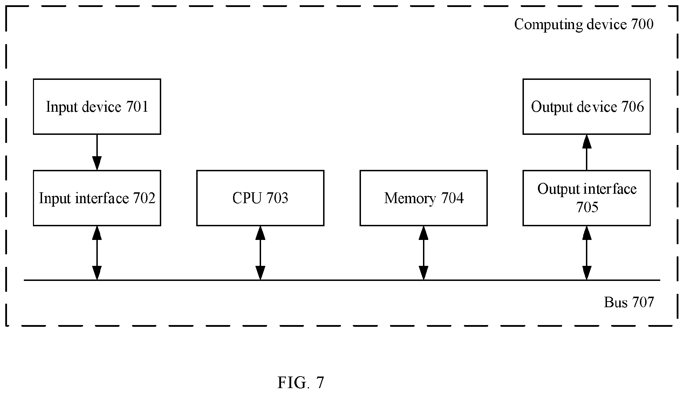

FIG. 7 is a block diagram showing an exemplary hardware architecture of a computing device capable of implementing the pattern information acquisition method and apparatus according to the present application.

As shown in FIG. 7, the computing device 700 includes an input device 701, an input interface 702, a central processing unit 703, a memory 704, an output interface 705, and an output device 706. The input interface 702, the central processing unit 703, the memory 704, and the output interface 705 are connected to each other via a bus 707, and the input device 701 and the output device 706 are connected to the bus 707 via the input interface 702 and the output interface 705, respectively, and further connected to other components of the computing device 700.

Specifically, the input device 701 receives input information from the outside, and transmits the input information to the central processing unit 703 through the input interface 702; the central processing unit 703 processes the input information based on computer-executable instructions stored in the memory 704 to generate output information, stores the output information temporarily or permanently on the memory 704, and then transmits the output information to the output device 706 through the output interface 705; and the output device 706 outputs the output information outside of the computing device 700 for use by a user.

In an embodiment, the computing device shown in FIG. 7 may be implemented as an electronic device including: a memory configured to store a program; and a processor configured to execute the program stored on the memory to implement the pattern information acquisition method according to any of the embodiments of the present application.

In an embodiment, the computing device shown in FIG. 7 may be implemented as a pattern information acquisition system including: a memory configured to store a program; and a processor configured to execute the program stored on the memory to implement the pattern information acquisition method according to any of the embodiments of the present application.

The above are merely exemplary embodiments of the present application and not intended to limit the scope of the present application. In general, the various embodiments of the present application may be implemented in hardware or special purpose circuits, software, logic or any combination thereof. For example, some aspects may be implemented in hardware, while other aspects may be implemented in firmware or software which may be executed by a controller, a microprocessor or any other computing device, although the present application is not limited thereto.

Embodiments of the present application may be implemented by a data processor of a mobile device executing computer program instructions, for example, in a processor entity, or by hardware, or by a combination of software and hardware. The computer program instructions may be assembler instructions, instruction set architecture (ISA) instructions, machine instructions, machine-related instructions, microcodes, firmware instructions, state setting data, or source or object codes written in any combination of one or more programming languages.

The block diagrams of any logic flow in the figures of the present application may represent program operations, or may represent interconnected logic circuits, modules, and functions, or may represent a combination of program operations and logic circuits, modules, and functions. The computer program may be stored on a memory. The memory may be of any type suitable to the local technical environment and may be implemented in any suitable data storage technology, such as but not limited to, read only memories (ROMs), random access memories (RAMs), optical storage devices or systems (digital versatile discs (DVDs), compact discs (CDs)), etc. The computer-readable medium may include a non-transitory storage medium. The data processor may be of any type suitable to the local technical environment, such as but not limited to, general purpose computers, dedicated computers, microprocessors, digital signal processors (DSPs), application specific integrated circuits (ASICs), field programmable gate arrays (FGPAs), and processors based on multi-core processor architecture.

The foregoing has provided by way of exemplary and non-limiting examples a detailed description of exemplary embodiments of the present application. Various modifications and adaptations to the foregoing embodiments may become apparent to those skilled in the art in view of the accompanying drawings and the appended claims, without departing from the scope of the present application. Accordingly, the proper scope of the present application is to be determined according to the claims.

## Claims

1. A pattern information acquisition method, comprising:
sorting, according to reliability weight information of polar codes, a sequence to be processed to obtain a weight-based sequence;
performing sequence search on the weight-based sequence to obtain a search result sequence, wherein the sequence search is used for acquiring a sequence corresponding to data having a reliability weight within a preset reliability threshold range; and
mapping the search result sequence to the sequence to be processed to obtain pattern information, wherein the pattern information indicates position information of data of the search result sequence in the sequence to be processed.

2. The method according to claim 1, wherein performing sequence search on the weight-based sequence to obtain the search result sequence comprises:
screening the weight-based sequence according to a preset search threshold to obtain the search result sequence, wherein data of the search result sequence has a reliability weight within the preset reliability threshold range; and
marking position information corresponding to a target code in the search result sequence.

3. The method according to claim 1, wherein performing sequence search on the weight-based sequence to obtain the search result sequence comprises:
performing sequence search on the weight-based sequence in a time division multiplexing mode to obtain the search result sequence.

4. The method according to claim 3, wherein performing sequence search on the weight-based sequence in a time division multiplexing mode to obtain the search result sequence comprises:
performing sequence search on the weight-based sequence in a time division multiplexing mode to obtain a frozen check sequence, a modulo five check sequence, and a first search sequence.

5. The method according to claim 4, wherein performing sequence search on the weight-based sequence in a time division multiplexing mode to obtain the frozen check sequence, the modulo five check sequence, and the first search sequence comprises:
acquiring a priority of the modulo five check sequence, a priority of the frozen check sequence, and a priority of the first search sequence;
performing sequence search on the weight-based sequence in a time division multiplexing mode according to the priorities, to obtain first check data in the frozen check sequence and the modulo five check sequence; and
performing sequence search on the weight-based sequence according to the priorities, to obtain the first search sequence.

6. The method according to claim 5, wherein the modulo five check sequence comprises second check data, and
after performing sequence search on the weight-based sequence according to the priorities to obtain the first search sequence, the method further comprises:
determining, according to a data length of the first search sequence and a preset length threshold, position information corresponding to the second check data.

7. The method according to claim 6, wherein determining, according to the data length of the first search sequence and the preset length threshold, the position information corresponding to the second check data comprises:
under a condition that the data length of the first search sequence is determined to be within a range of the preset length threshold, determining a position type set corresponding to the second check data, wherein the position type set corresponding to the second check data comprises a number of position types and a position type corresponding to the second check data, and the number of position types corresponds to the preset length threshold;
selecting a position type corresponding to the second check data from the position type set corresponding to the second check data; and
determining, according to the position type corresponding to the second check data, position information corresponding to the second check data.

8. The method according to any one of claims 5 to 7, wherein after performing sequence search on the weight-based sequence according to the priorities to obtain the first search sequence, the method further comprises:
performing sequence search on the first search sequence according to the priorities, to obtain a communication information sequence and a cyclic redundancy check sequence.

9. The method according to claim 5, wherein each of the priorities is proportional to the reliability weight of the corresponding sequence.

10. The method according to claim 5, wherein the priority of the modulo five check sequence is higher than the priority of the frozen check sequence.

11. The method according to claim 8, wherein mapping the search result sequence to the sequence to be processed to obtain the pattern information comprises:
mapping the communication information sequence, the cyclic redundancy check sequence, the modulo five check sequence, and the frozen check sequence to the sequence to be processed, to obtain the pattern information.

12. The method according to claim 8, wherein after mapping the search result sequence to the sequence to be processed to obtain the pattern information, the method further comprises:
determining, according to the pattern information, decoding start position information in the sequence to be processed.

13. The method according to claim 8, wherein before sorting, according to the reliability weight information of polar codes, the sequence to be processed to obtain the weight-based sequence, the method further comprises:
acquiring a data length of the communication information sequence, a data length of an input sequence, and a matched data length, wherein the matched data length is a data length of a sequence obtained after the input sequence is subjected to rate matching;
determining position information of an initial frozen bit according to the data length of the communication information sequence, the data length of the input sequence, the matched data length, and an interleaving rule of the polar codes; and
determining the sequence to be processed according to the position information of the initial frozen bit and the input sequence.

14. The method according to any one of claims 1 to 13, wherein the reliability weight information of the polar codes comprises: preset data position information, and a reliability weight corresponding to the preset data position information, and
sorting, according to the reliability weight information of polar codes, the sequence to be processed to obtain the weight-based sequence comprises:
searching the reliability weight information of the polar codes according to the position information of the data in the sequence to be processed, to obtain a reliability weight corresponding to the data in the sequence to be processed; and
sorting, according to the reliability weight corresponding to the data in the sequence to be processed, the data in the sequence to be processed in a descending order to obtain the weight-based sequence.

15. A pattern information acquisition apparatus, comprising:
an acquisition module configured to sort, according to reliability weight information of polar codes, a sequence to be processed to obtain a weight-based sequence;
a search module configured to perform sequence search on the weight-based sequence to obtain a search result sequence, wherein the sequence search is used for acquiring a sequence corresponding to data having a reliability weight within a preset reliability threshold range; and
a mapping module configured to map the search result sequence to the sequence to be processed to obtain pattern information, wherein the pattern information indicates position information of data of the search result sequence in the sequence to be processed.

16. A decoder, comprising the pattern information acquisition apparatus according to claim 15.

17. An electronic device, comprising:
one or more processors; and
a memory having one or more programs stored thereon which, when executed by the one or more processors, cause the one or more processors to implement the pattern information acquisition method according to any one of claims 1 to 14.

18. A readable storage medium, wherein the readable storage medium has a computer program stored thereon which, when executed by a processor, cause the processor to implement the pattern information acquisition method according to any one of claims 1 to 14.
